# EUROPEAN PATENT APPLICATION

(11) **EP 1 363 324 A1**
(43) Date of publication of application: **19.11.2003**
(21) Application number: 02425311.4
(22) Date of filing: 16.05.2002
(51) Int. Cl.: H01L 21/8247, H01L 27/105, H01L 21/321

(54) **Method for manufacturing non-volatile memory device**

(71) Applicant: STMicroelectronics S.r.l., 20041 Agrate Brianza (Milano) (IT)
(72) Inventor: Pividori, Luca, 24035 Curno, Bergamo (IT); Calareso, Carmen, 20099 Sesto San Giovanni, Milano (IT)
(74) Representative: Botti, Mario

(57) **Abstract**

A method of manufacturing non-volatile memory devices, comprises the following steps:
- depositing a first layer (3) onto a semiconductor substrate;
- defining and selectively removing said first layer (4) to form a portion (5) of said first layer (4);
- depositing a second layer (7) to a first thickness over the entire memory device;
- forming a screening layer (8) on the second layer (7) to leave uncovered at least a portion (10) of the second layer (7) aligned to the portion (5) of the first layer (3); and
- partly removing the portion (10) of the second layer (7) such that the thickness of the portion (10) of the second layer (7) is made smaller than the first thickness.

## Description

### Field of Application

The present invention relates to a method of manufacturing non-volatile memory devices.

The invention specifically relates to a method of manufacturing non-volatile memory devices, which method comprises the following steps:
- depositing a first layer onto a semiconductor substrate;
- defining and selectively removing said first layer to form a portion of said first layer;
- depositing a second layer to a first thickness onto the entire memory device.

Although not limited to, the invention relates in particular to a method for improving the planarity of semiconductor integrated electronic devices, for instance, as the polysilicon gate electrode is defined during a non-volatile memory manufacturing process, the following description making reference to this field of application for convenience of illustration only.

### Prior Art

As is well known, electronic non-volatile memory devices, e.g. flash memories, integrated in a semiconductor comprise a plurality of non-volatile memory cells arranged as an array, specifically an array of row or wordlines and columns or bitlines.

Each non-volatile memory cell comprises a MOS transistor having a floating gate electrode, this being an electrode that locates above its channel region and has a high DC impedance to all the other terminals of both the cell and the cell host circuit.

The cell has a second or gate control electrode coupled capacitively to the floating gate electrode through an intermediate dielectric layer, known as the interpoly layer. The second electrode of the cell is driven by appropriate control voltages. Other transistor electrodes are the ordinary drain and source terminals.

In general, the memory cell array is associated control circuitry that includes a conventional MOS transistor, having a source region separated from a drain region by a channel region. A gate electrode is also formed over the channel region and isolated from the latter by a gate oxide layer.

The process steps for manufacturing a memory array and its circuitry are the following:
- forming active areas for the memory array and circuitry;
- growing a layer of an active oxide, known as the tunnel oxide, over the active areas;
- depositing a first polysilicon layer onto the whole device;
- defining floating gate electrodes in the array region;
- depositing a dielectric or interpoly layer, e.g. of ONO (Oxide /Nitrate/Oxide);
- forming a photolithographic mask, referred to as the MATRIX mask, on the memory array for etching through the interpoly layer and the first polysilicon layer of the circuitry;
- growing one or more active gate oxides over both the circuitry and the memory array;
- depositing a second polysilicon layer;
- defining the control gate electrodes of the array cells in said second polysilicon layer by exposing through a SAE (Self-Aligned Etch) mask;
- defining the gate electrodes of the transistors in the circuitry by - exposing through the circuitry mask; and
- forming the transistor source and drain regions and metal layers.

In this way, the memory cell transistors, comprising two polysilicon layers, are formed thicker than the circuitry transistors.

In particular, memory devices realized with technologies that effectively define dimension of 0.15 µm or less, the difference in thickness between the array regions where the memory cells are provided and the circuitry regions where the control devices are provided becomes more and more substantial.

In particular, the thickness of the second polysilicon layer, which is deposited onto the first polysilicon layer to realize the control gate electrodes of the memory cells and the gate electrodes of the circuitry transistors formed simultaneously therein, will be much smaller then the combined layers that are deposited to form a memory cell.

In the instance of a flash memory cell, the overall thickness of the stack structure, comprised of the tunnel oxide, first polysilicon, interpoly dielectric, and second polysilicon layers, may be approximately 4100 Å, with a thickness of the stack structure of the circuitry, comprised of the gate oxide and second polysilicon layers, that amounts to 2600 Å.

Therefore, the array has a thickness increase of about 1500 Å over the circuitry. This difference creates a "step" between the array and the circuitry structure, which disallows a uniform spread over the device regions of subsequently applied layers, such as anti-reflective BARC layers or layers of a light-sensitive material employed to define the polysilicon layers of the memory cells.

On account of these thickness differences on the device, there will be formed some regions of uniform thickness where the required lithographic dimensions can be correctly defined for the memory cells, and some regions of non-uniform thickness where problems of local lithographic focusing can be observed. The result is a memory cell gate electrode whose dimensions are different from specifications, being usually narrower than is required for proper performance of the device.

In this situation, reliability of the device is lost in significant amounts, enough to induce the rejection of the device and loss of yield already during the testing stage.

It can be appreciated, therefore, that a difference in thickness between circuit structures can hinder a (dimension-wise) correct definition of each portion in the broad region where the memory array is formed. As just mentioned, this difference in thickness can be due to different steps of the manufacturing process.

The underlying technical problem of this invention is to provide a method of manufacturing circuit structures, which has features appropriate to ensure uniform thickness of the several portions of an electronic circuit, and to overcome the limitations and/or shortcomings of prior devices.

### Summary of the Invention

The resolvent idea of this invention is one of carrying out an etching step on any circuit structures of greater thickness than other circuit structures, whereby the thickness of the former can be reduced and made uniform with the thickness of the integrated circuit.

Based on this idea, the technical problem is solved by a method as previously indicated and as defined in the characterizing part of Claim 1.

The features and advantages of the method of this invention will be apparent from the following description, given by way of non-limitative example with reference to the accompanying drawings.

### Brief Description of the Drawings

In the drawings:

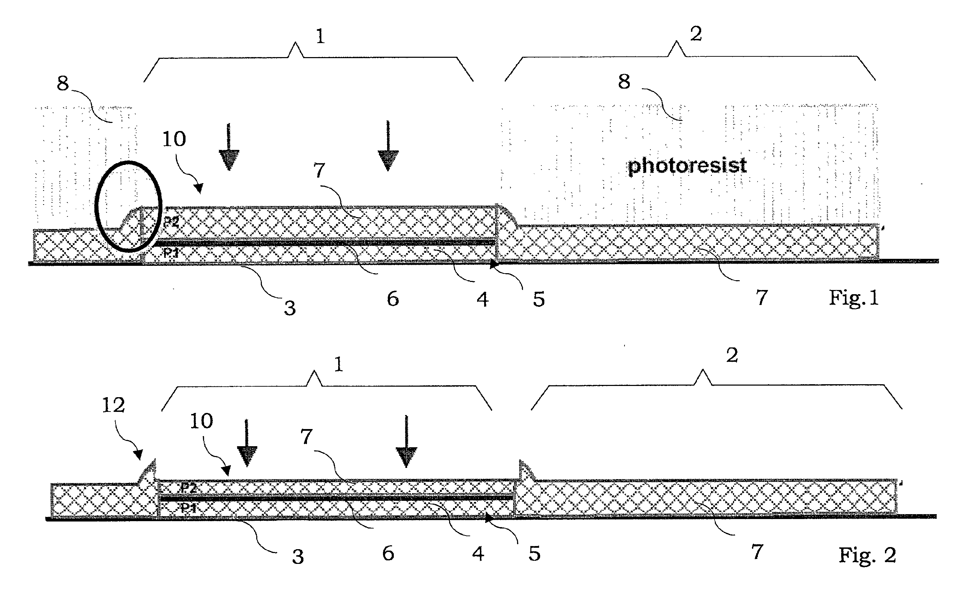

Figures 1 to 4 are respective schematic sectional views of a portion of an integrated circuit during the successive steps of the method according to the invention.

### Detailed Description

The processing steps described herein are not exhaustive of an integrated circuit manufacturing process. This invention can be implemented along with techniques that are conventional in the manufacturing of integrated circuits, and only such conventional manufacturing steps will be considered as may come useful in disclosing the invention.

The cross-section views provided by the drawings to illustrate portions of an integrated circuit during its manufacturing process are not drawn to scale but rather to delineate major features of the invention.

A method of manufacturing non-volatile memory devices will now be described with reference to the drawing views.

As said before, electronic non-volatile memory devices, e.g. flash memories, integrated in a semiconductor, comprise a plurality of non-volatile memory cells laid out as an array of such cells, with the cells arranged into rows or wordlines and columns or bitlines.

Each non-volatile memory cell comprises a MOS transistor having, located above its channel region, a floating gate electrode, i.e. an electrode that has a high DC impedance to all the other terminals of the cell and the cell host circuit.

The cell has also a second or gate control electrode coupled capacitively to the floating gate electrode through an intermediate dielectric layer, known as the interpoly layer. The second electrode of the cell is driven by appropriate control voltages. Other transistor electrodes are the ordinary drain and source terminals.

In the state of the art, the memory cell array is associated control circuitry that includes conventional MOS transistors, each having a source region separated from a drain region by a channel region. A gate electrode is also formed over the channel region and isolated from the latter by a gate oxide layer.

The process steps for manufacturing the memory array 1 and its circuitry 2 include the following:
- forming active areas for the memory array 1 and circuitry 2;
- growing a layer 3 of an active oxide, known as the tunnel oxide, over the active areas;
- depositing a first polysilicon layer 4 onto the whole device;
- defining floating gate electrodes 5 for the memory array 1 in the first polysilicon layer 4;
- depositing a dielectric or interpoly layer 6, e.g. of ONO (Oxide/ Nitrate/Oxide);
- forming a photolithographic mask, referred to as the MATRIX mask, on the memory array 1 for etching the interpoly layer and first polysilicon layer away from the circuitry;
- growing at least one active gate oxide layer over the circuitry 2;
- depositing a second polysilicon layer 7 onto both the circuitry 2 and the memory array 1, thereby to provide control gate regions 9 of the memory cells and gate regions of the circuitry transistors.

According to the invention, a photolithography mask 8 is formed at this step which will cover the circuitry 2 but for a portion 10, aligned to the memory array 1, of the polysilicon layer 7, as shown in Figure 1.

This mask 8 advantageously leaves uncovered also an outer peripheral portion of the memory cell array 1. This mask 8 realizes a screening layer for the polysilicon layer 7.

An etching operation is then performed on the second polysilicon layer 7. This will reduce the thickness of the second polysilicon 7 and, hence, that of the whole memory cell in the array.

Advantageously in this invention, approximately one third the thickness of the second polysilicon layer 7 is removed.

The second polysilicon layer 7 is advantageously applied a dry etch.

The mask 8 is then removed as shown in Figure 2.

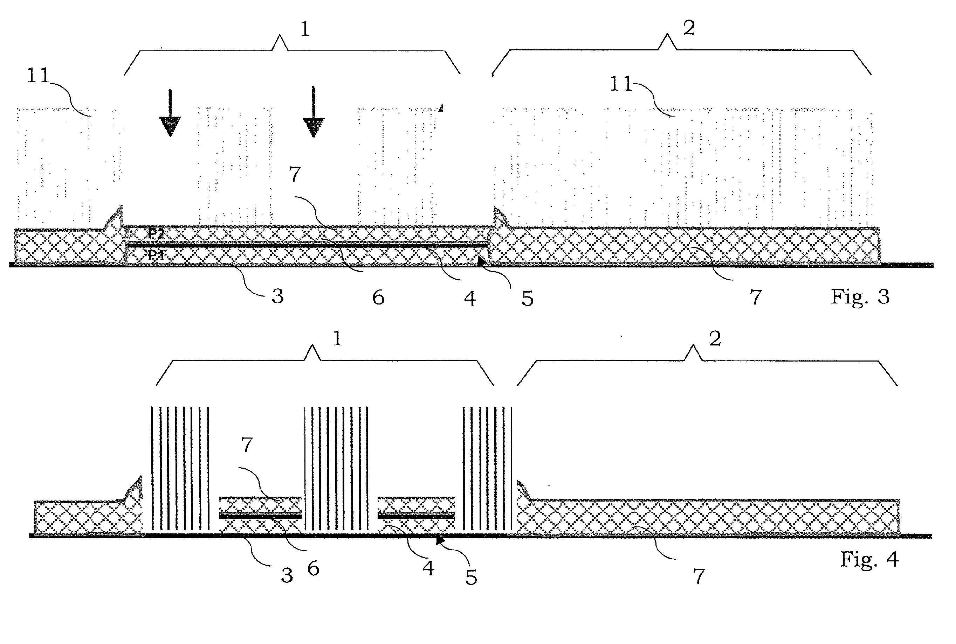

The memory device manufacturing process of the invention is now continued conventionally to form a self-aligned etching mask 11 as shown in Figure 3.

Thereafter, a conventional etching step is carried out to define the floating gate electrodes of the memory cells, as shown in Figure 4. Conventional processing steps will ultimately form finished memory cells and circuitry transistors.

Advantageously, the etching should leave protuberances 12 on the second polysilicon layer 7, at the memory array periphery. Such protuberances are not removed by the etch because screened by the mask 8. These protuberances can be utilized to advantage as a barrier for the layers later to be deposited.

Summarizing, the method of this invention allows the thickness of the second polysilicon layer to be reduced, such that any non-uniformity of the layer and from the underlying structures can be smoothed away.

Advantageously, the problems in defining photolithographically the next layers due to a different thickness of the underlying layer are thus removed.

In particular, the process of this invention is advantageous especially when only portions of the electronic device require to be smoothed.

In the latter respect, the invention enables selective etching of the structures to be leveled off. By such selective etching, both a layer thickness to be attenuated and the size of the layer portion affected by the removal can be accurately controlled.

Although reference is made in the above description to memory cell formation that comprise a floating gate transistor, the process of this invention is also useful where other areas of circuit structures provided in an integrated circuit require to be smoothed.

## Claims

1. A method of manufacturing non-volatile memory devices, comprising the following steps:
- depositing a first layer (3) onto a semiconductor substrate;
- defining and selectively removing said first layer (4) to form a portion (5) of said first layer (4);
- depositing a second layer (7) to a first thickness over the entire memory device;
the method being **characterized in that** it comprises the following steps:
- forming a screening layer (8) on said second layer (7) to leave uncovered at least a portion (10) of said second layer (7) aligned to said portion (5) of said first layer (3); and
- partly removing said portion (10) of said second layer (7) such that the thickness of said portion (10) of said second layer (7) is made smaller than said first thickness.

2. A method of manufacturing memory devices according to Claim 1, **characterized in that** said step of partly removing said portion (10) of said second layer (7) is a dry etching step.

3. A method of manufacturing memory devices according to Claim 1, **characterized in that** said step of partly removing said portion (10) of said second layer (7) is effective to remove about one third of said layer thickness.

4. A method of manufacturing memory devices according to Claim 1, **characterized in that** said screening layer (8) leaves uncovered a portion (10) of the second layer (7) that is larger than the first portion (5).

5. A method of manufacturing memory devices according to Claim 4, **characterized in that** a barrier layer (12) is formed around said portion (10) of the second layer (7).

6. A method of manufacturing memory devices according to Claim 1, **characterized in that** a third layer (3) is deposited between said semiconductor substrate and said first layer (4), and that a fourth layer (6) is deposited between said first layer (4) and said second layer (7).

7. A method of manufacturing memory devices according to Claim 6, **characterized in that** said first and second layers are identical.

8. A method of manufacturing memory devices according to Claim 7, **characterized in that** said first and second layers are polysilicon layers.

9. A method of manufacturing memory devices according to Claim 6, **characterized in that** said third and fourth layers (3,6) are a dielectric layer.

10. A method of manufacturing memory devices according to Claim 7, **characterized in that** the floating gate and control gate regions, respectively, of a memory cell are provided in said first and second layers (4,7), respectively.
